# EUROPEAN PATENT APPLICATION

(11) **EP 4 651 683 A1**
(43) Date of publication of application: **19.11.2025**
(21) Application number: 25170320.3
(22) Date of filing: 14.04.2025
(51) Int. Cl.: H10H 29/80, H10H 29/49

(54) **TRANSPARENT LED DISPLAY**

(30) Priority: 16.05.2024 JP 2024079883
(71) Applicant: Alps Alpine Co., Ltd., Ota-ku, Tokyo 145-8501 (JP)
(72) Inventor: Kishida, Katsuhiko, Iwaki-city Fukushima (JP)
(74) Representative: Schmitt-Nilson Schraud Waibel Wohlfrom Patentanwälte Partnerschaft mbB

(57) **Abstract**

A transparent LED display includes a transparent substrate, pairs of electrodes arranged in an array on the transparent substrate, LEDs each arranged between a corresponding one of the pairs of electrodes, and apertures provided on the transparent substrate, the apertures being areas free of the electrodes and allowing light to pass through, wherein the LEDs are arranged on both of a first surface and a second surface of the transparent substrate, and each of the electrodes on the second surface is arranged in a second surface shielding region including a region that shields a light path extending from one of the LEDs arranged on the first surface through the transparent substrate, and each of the electrodes on the first surface is arranged in a first surface shielding region including a region that shields a light path extending from the LEDs on the second surface through the transparent substrate.

## Description

The disclosures herein relate to transparent LED displays, and are particularly suitable for use in a display including a transparent substrate, a plurality of pairs of electrodes arranged in an array on the transparent substrate, a plurality of LEDs each arranged between a corresponding one of the pairs of electrodes, and a plurality of apertures provided on the transparent substrate, the apertures being areas free of the electrodes and allowing light to pass through.

In the related arts, different from general displays, a transparent display, whose background is transparent, is known. In the transparent display, a plurality of light sources are arranged in an array on a transparent substrate, and a plurality of apertures are provided, the apertures being areas free of the electrodes and allowing light to pass through from the rear to the front of the display. A ratio of an area of the apertures to one pixel area is called an aperture ratio, and the larger the aperture ratio, the more background light can be received, and the more transparent the display can be.

There are various types of transparent displays. Among them, transparent LED displays are expected to be used in various applications because they can achieve a high transmittance of more than 70%. When constructing the transparent LED display, it is preferable to use a technology called micro-LED, which consists of miniaturized LEDs used as light sources and arranged in an array. The display using micro-LED is disclosed, for example, in Patent Literature (PTL) 1.

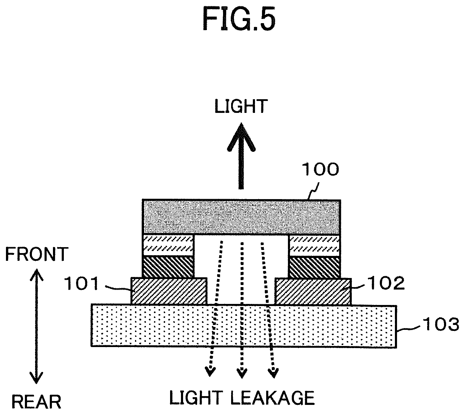

However, when the transparent LED display is constructed using micro-LEDs, as shown in FIG. 5, there is a problem that light emitted from a LED 100 to project information on the display surface leaks to the rear of a transparent substrate 103 through a gap between an anode electrode 101 and a cathode electrode 102. In the transparent LED display, since the substrate disposed on the rear of the LED 100 is also composed of the transparent substrate 103, when the LED 100 is lit, light leaks from the rear of the LED 100 to the rear of the display through the gap between the electrodes 101 and 102.

Note that, a display device capable of extracting light emitted from the rear of a light-emitting element chip to the front is known (see, e.g., PTL 2). In the display device described in PTL 2, an LED chip is provided on a circuit board, and an interconnect pattern of the circuit board is made of a material having light reflectivity, such as aluminum. By using a part of a light-reflective interconnect pattern as a chip mounting layer and directly mounting the light-emitting element chip on the chip mounting layer, the light emitted from the rear of the light-emitting element chip can be extracted to the front with a simple configuration.

The present invention has been developed to solve the aforementioned problems. It aims to prevent light emitted by an LED when it is lit from leaking to the opposite surface of a transparent substrate in a transparent LED display.

### CITATION LIST

### PATENT LITERATURE

[PTL 1] Japanese Laid-Open Patent Publication No. 2021-52156
[PTL 2] Japanese Laid-Open Patent Publication No. 2012-204370

The present disclosure relates to a transparent LED display according to the appended claims. Embodiments are disclosed in the dependent claims.

A transparent LED display according to an aspect includes a transparent substrate, a plurality of pairs of electrodes arranged in an array on the transparent substrate, a plurality of LEDs each arranged between a corresponding one of the pairs of electrodes, and a plurality of apertures provided on the transparent substrate, the apertures being areas free of the electrodes and allowing light to pass through, wherein the plurality of LEDs are arranged on both of a first surface and a second surface, which is opposite to the first surface, of the transparent substrate, and each of the electrodes on the second surface is arranged in a second surface shielding region including a region that shields a light path extending from one of the LEDs arranged on the first surface through the transparent substrate, and each of the electrodes on the first surface is arranged in a first surface shielding region including a region that shields a light path extending from the LEDs on the second surface through the transparent substrate.

According to aspects of the present invention, in the transparent LED display, the light emitted from the rear surface of the LED on the first surface toward the transparent substrate when the LED on the first surface is lit is shielded by the electrodes on the second surface, and light emitted from the rear surface of the LED on the second surface toward the transparent substrate when the LED on the second surface is lit is shielded by the electrodes on the first surface, so that irradiation light emitted from the LED can be prevented from leaking to the opposite surface of the transparent substrate.
FIG. 1 is a drawing schematically illustrating an example of LED arrangement in a transparent LED display according to an embodiment;
FIG. 2 is a cross-sectional view illustrating an LED arrangement structure in the transparent LED display according to an embodiment;
FIG. 3 is a cross-sectional view illustrating another example of LED arrangement in the transparent LED display according to an embodiment;
FIG. 4 is a cross-sectional view illustrating the other example of LED arrangement in the transparent LED display according to an embodiment; and
FIG. 5 is a cross-sectional view illustrating the structure of the light emitting part of a transparent LED display.

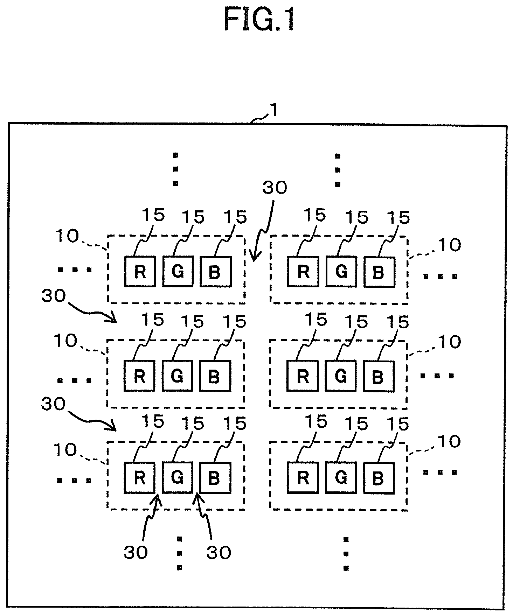

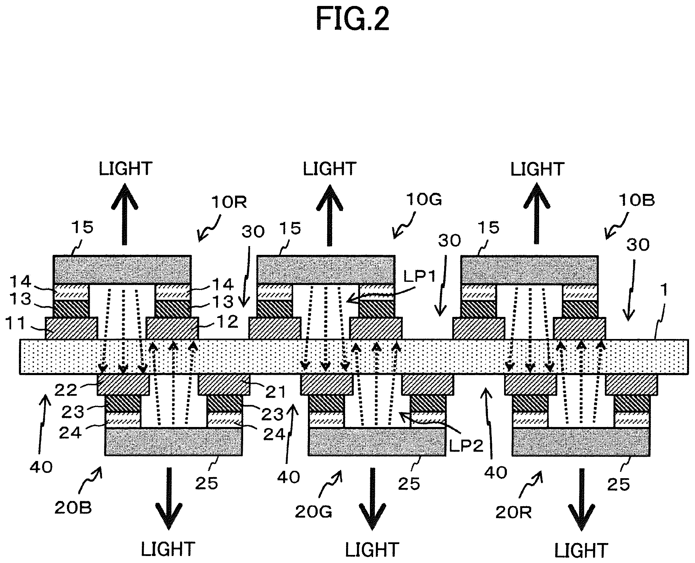

In the following, embodiments of the present invention will be described with reference to the accompanying drawings. FIGS. 1 and 2 are drawings illustrating an LED arrangement structure in a transparent LED display according to an embodiment. FIG. 1 is a drawing schematically illustrating the LED arrangement in the transparent LED display viewed from above a transparent substrate 1 (in a first surface direction described later). In the present embodiment, as an example, a configuration example of a transparent LED display using micro-LED elements.

As shown in FIG. 1, the transparent LED display of the present embodiment is a display in which each of a plurality of LEDs 15 is arranged between a corresponding one of a plurality of pairs of electrodes (not shown) arranged in an array on the transparent substrate 1, and a plurality of apertures 30 provided on the transparent substrate 1, the plurality of apertures 30 being areas free of the electrodes and allowing light to pass through. Thus, the light of the background is transmitted from the rear to the front of the display, and the background of the display can be seen through from the front.

In the LED arrangement shown in FIG. 1, one pixel 10 is composed of three sub-pixels (shown in FIG. 2 as 10R, 10G and 10B) having LEDs 15 (red, green, and blue LEDs) for each RGB. The apertures 30 are formed between adjacent sub-pixels within the sub-pixels 10R, 10G, and 10B, and between adjacent pixels 10. Although a configuration with sub-pixels in which three LEDs 15 of RGB are arranged in one pixel 10 is shown here, a configuration without sub-pixels in which one LED 15 is arranged in one pixel may be used.

FIG. 2 is a cross-sectional view illustrating an LED arrangement structure in the transparent LED display according to an embodiment. The upside of the drawing is a first surface of the transparent substrate 1, and the downside of the drawing is a second surface of the transparent substrate 1, which is opposite to the first surface.

As shown in FIG. 2, in the transparent LED display of the present embodiment, a plurality of LEDs 15 and 25 are arranged on the first and second surfaces of the transparent substrate 1, respectively. FIG. 2 shows the LED arrangement structure of one pixel. In the first surface, one pixel includes the plurality of sub-pixels 10R, 10G, and 10B corresponding to red light emission, green light emission, and blue light emission, and the LED 15 is arranged for each of the sub-pixels 10R, 10G, and 10B. Similarly, in the second surface, one pixel includes a plurality of sub-pixels 20R, 20G, and 20B, and the LED 25 is arranged for each sub-pixel 20R, 20G, and 20B.

In each of the sub-pixels 10R, 10G, and 10B of the first surface, a pair of an anode electrode 11 and a cathode electrode 12 are arranged on the transparent substrate 1 at predetermined intervals, and the LED 15 is arranged and electrically connected between the electrodes 11 and 12. In the example of FIG. 2, the LED 15 is mounted on a bonding material 13 formed on the electrodes 11 and 12 via bumps 14. The apertures 30 being areas free of the electrodes 11 and 12 are provided between adjacent sub-pixels within the sub-pixels 10R, 10G, and 10B.

The second surface of the transparent substrate 1 has the same structure as the first surface. That is, each of the sub-pixels 20R, 20G, and 20B on the second surface has a pair of an anode electrode 21 and a cathode electrode 22 arranged on the transparent substrate 1 at predetermined intervals, and the LED 25 is arranged and electrically connected between the electrodes 21 and 22. In the example of FIG. 2, the LED 25 is mounted on the bonding material 23 formed on the electrodes 21 and 22 via bumps 24. Apertures 40 being areas free of the electrodes 21 and 22 are provided between adjacent sub-pixels within the sub-pixels 20R, 20G, and 20B.

In the present embodiment, the cathode electrode 22 on the second surface is arranged in the second surface shielding region including a region for shielding a light path LP1 (indicated by dotted arrows) in a direction from the rear of the LED 15 arranged on the first surface toward the transparent substrate 1, and the cathode electrode 12 on the first surface is arranged in the first surface shielding region including a region for shielding a light path LP2 (indicated by dotted arrows) in the direction from the rear of the LED 25 arranged on the second surface toward the transparent substrate 1.

That is, the cathode electrode 12 (corresponding to one electrode of the claims) of the sub-pixels 10R, 10G, and 10B of the first surface is arranged in the first surface shielding region opposite the sub-pixels 20R, 20G, and 20B of the second surface. The cathode electrode 22 (one electrode) of the sub-pixels 20R, 20G, and 20B of the second surface is arranged in the second surface shielding region opposite the sub-pixels 10R, 10G, and 10B of the first surface.

The second surface shielding region including the region shielding the light path LP1 means that it may include at least the region shielding the light path LP1 (the region of the second surface facing the region of the first surface blocking a space between the electrodes 11, 12), and may be a region of the same size as the region shielding the light path LP1 or a region larger than that. Similarly, the first surface shielding region including the region shielding the light path LP2 means that it may include at least the region shielding the light path LP2 (the region of the first surface facing the region of the second surface blocking a space between the electrodes 21 and 22), and may be a region of the same size as the region shielding the light path LP2 or a region larger than that. FIG. 2 shows an example in which the regions having the same size as the regions shielding the light paths LP1 and LP2 are the first surface shielding region and the second surface shielding region.

With such an LED arrangement structure, the light of the light path LP1 emitted from the rear surface of the LED 15 on the first surface toward the transparent substrate 1 when the LED 15 on the first surface is lit is shielded by the cathode electrode 22 on the second surface. The light of the light path LP2 emitted from the rear surface of the LED 25 on the second surface toward the transparent substrate 1 when the LED 25 on the second surface is lit is shielded by the cathode electrode 12 on the first surface. Therefore, irradiation light of the LEDs 15 and 25 can be prevented from leaking to the opposite surface of the transparent substrate 1.

The anode electrode 11 (corresponding to the other electrode in the claims) of the sub-pixels 10R, 10G and 10B of the first surface is arranged in a first surface region, which is opposite the corresponding sub-pixels 20R, 20G and 20B on the second surface (a region opposite to the apertures 40 of the second surface). The anode electrode 21 (the other electrode) of the sub-pixels 20R, 20G and 20B of the second surface is arranged in the first surface region, which is opposite the corresponding sub-pixels 10R, 10G and 10B of the first surface (a region opposite to the apertures 30 of the first surface).

In the example shown in FIG. 2, the first surface region, in which the anode electrode 11 is arranged on the first surface, is a region that encompasses an entire region of the apertures 40 formed between corresponding sub-pixels 20R, 20G and 20B on the second surface in plan view. Plan view refers to observing the transparent LED display in a direction perpendicular to the surface of the transparent substrate 1. A second surface region, in which the anode electrode 21 is arranged on the second surface, is a region that encompasses an entire region of the apertures 30 formed between corresponding sub-pixels 10R, 10G and 10B on the first surface in plan view.

The first surface region that encompasses the entire region of the apertures 40 means that it may at least encompass the entire region of the apertures 40, and may be a region of the same size as or larger than the region concerned. Similarly, the second surface region that encompasses the entire region of the apertures 30 means that it may at least encompass the entire region of the apertures 30, and may be a region of the same size as or larger than the region concerned. FIG. 2 shows an example in which a region having the same size as the region facing all the regions of the apertures 30 and 40 is designated as the first surface region and the second surface region.

With this configuration, light that may leak out of the sub-pixels 10R, 10G, and 10B from the rear surface of the LED 15 on the first surface when the LED 15 on the first surface is turned on is shielded by the anode electrode 21 on the second surface. Also, light that may leak out of the sub-pixels 20R, 20G, and 20B from the rear surface of the LED 25 on the second surface when the LED 25 on the second surface is turned on is shielded by the anode electrode 11 on the first surface. Thus, it is possible to more effectively prevent the irradiation light of the LEDs 15 and 25 from leaking to the opposite surface of the transparent substrate 1.

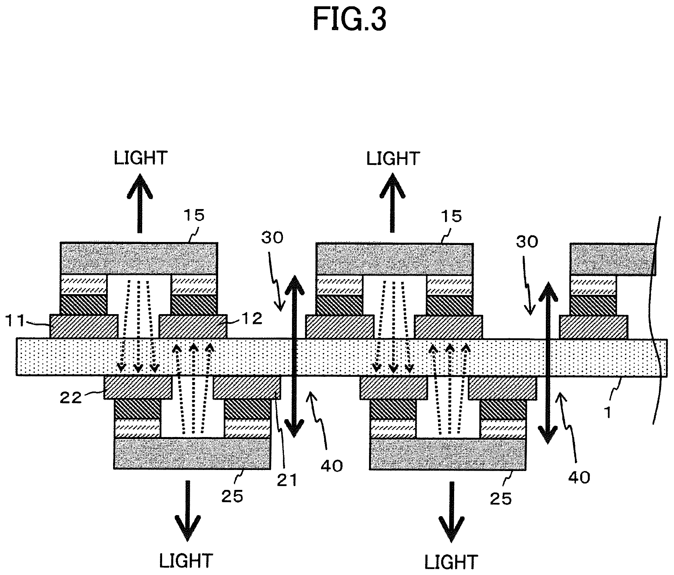

As shown in FIG. 3, the first surface region, in which the anode electrode 11 is arranged on the first surface, may cover only a part of a region of the apertures 40 formed between corresponding sub-pixels on the second surface in plan view, and the second surface region, in which the anode electrode 21 is arranged on the second surface, may cover only a part of a region of the apertures 30 formed between corresponding sub-pixels on the first surface in plan view. In this way, light that may leak out of the sub-pixels 10R, 10G, 10B, 20R, 20G, and 20B from the rear surface of the LEDs 15 and 25 from leaking to the opposite surface of the transparent substrate 1 can be suppressed to some extent, and transparency of the transparent LED display can be increased by increasing the aperture ratio. FIG. 3 shows an example (example in which the size of the cathode electrodes 12 and 22 is larger than the area for shielding the light paths LP1 and LP2) in which areas larger than the areas shielding the light paths LP1 and LP2 are used as the first and second surface shielding areas.

In addition, the electrodes arranged in the first and second surface shielding regions may be arranged in a configuration opposite to that of the above embodiment. That is, the anode electrode 11 of the first surface may be arranged in the first surface shielding region, which is opposite a corresponding one of the sub-pixels 20R, 20G, and 20B on the second surface, and the cathode electrode 12 may be arranged in the first surface region including a region that is not opposite any one of the sub-pixels 20R, 20G, and 20B on the second surface, while the anode electrode 21 of the second surface may be arranged in the first surface shielding region, which is opposite a corresponding one of the sub-pixels 10R, 10G, and 10B of the first surface, and the cathode electrode 22 may be arranged in the second surface region including a region that is not opposite any one of the sub-pixels 10R, 10G, and 10B of the first surface.

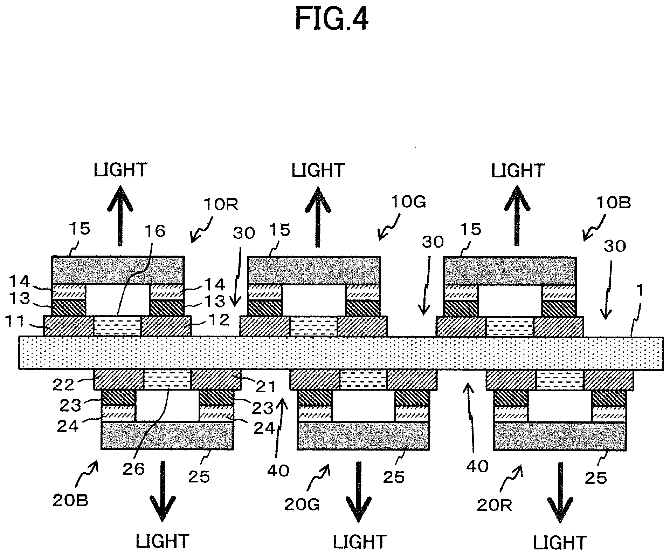

Further, as shown in FIG. 4, a reflective member 16 having light reflectivity may be arranged between each pair of electrodes 11 and 12 on the first surface, and the reflective member 26 may be arranged between each pair of electrodes 21 and 22 on the second surface. FIG. 4 shows an example of a configuration in which the reflective member 16 is arranged in a region blocking the space between the electrodes 11 and 12 on the first surface, and the reflective member 26 is arranged in a region blocking the space between the electrodes 21 and 22 on the second surface. It is not essential to arrange the reflective members 16 and 26 in a region completely blocking a space between electrodes.

By providing the reflective members 16 and 26 as shown in FIG. 4, light utilization efficiency can be improved by reflecting the light of the light path LP1 emitted from the rear surface of the LED 15 on the first surface toward the transparent substrate 1 to an information display surface of the first surface, and by reflecting the light of the light path LP2 emitted from the rear surface of the LED 25 on the second surface toward the transparent substrate 1 to the information display surface of the second surface. In addition, light that may pass through the reflective members 16 and 26 can be shielded by the cathode electrodes 12 and 22 on the first and second surfaces.

In the above embodiment, the configuration of the transparent LED display using micro-LED elements has been described, but is not limited to the embodiment described above. That is, the LED arrangement structure of the present embodiment can be applied to a transparent LED display having a structure in which the irradiation light of the LED leaks from a gap between electrodes.

Further, the present invention is not limited to these embodiments, but various variations and modifications may be made without departing from the scope of the claims.

## Claims

1. A transparent LED display, comprising:
a transparent substrate;
a plurality of pairs of electrodes arranged in an array on the transparent substrate;
a plurality of LEDs each arranged between a corresponding one of the pairs of electrodes; and
a plurality of apertures provided on the transparent substrate, the apertures being areas free of the electrodes and allowing light to pass through,
wherein:
the plurality of LEDs are arranged on both of a first surface and a second surface, which is opposite to the first surface, of the transparent substrate; and
each of the electrodes on the second surface is arranged in a second surface shielding region including a region that shields a light path extending from one of the LEDs arranged on the first surface through the transparent substrate, and each of the electrodes on the first surface is arranged in a first surface shielding region including a region that shields a light path extending from the LEDs on the second surface through the transparent substrate.

2. The transparent LED display according to claim 1, further comprising reflective members having light reflectivity, wherein one of the reflective members is arranged between each pair of the electrodes on the first surface, and one of the reflective members is arranged between each pair of the electrodes on the second surface.

3. The transparent LED display according to claim 1 or 2, wherein:
one pixel includes a plurality of sub-pixels, and one of the LEDs is arranged corresponding to each of the sub-pixels;
in each pair of the electrodes arranged on the first surface, while one electrode of the electrodes is arranged in the first surface shielding region, which is opposite a corresponding one of the sub-pixels on the second surface across the transparent substrate, another electrode is arranged in a first surface region including a region that is not opposite any one of the sub-pixels on the second surface across the transparent substrate; and
in each pair of the electrodes arranged on the second surface, while one electrode of the electrodes is arranged in the second surface shielding region, which is opposite a corresponding one of the sub-pixels on the first surface across the transparent substrate, another electrode is arranged in a second surface region including a region that is not opposite any one of the sub-pixels on the first surface across the transparent substrate.

4. The transparent LED display according to claim 3, wherein:
the first surface region, in which the another electrode is arranged on the first surface, is a region that encompasses an entire region of apertures formed between corresponding sub-pixels on the second surface in plan view; and
the second surface region, in which the another electrode is arranged on the second surface, is a region that encompasses an entire region of apertures formed between corresponding sub-pixels on the first surface in plan view.

5. The transparent LED display according to claim 3, wherein:
the first surface region, in which the another electrode is arranged on the first surface, covers only a part of a region of apertures formed between corresponding sub-pixels on the second surface in plan view; and
the second surface region, in which the another electrode is arranged on the second surface, covers only a part of a region of apertures formed between corresponding sub-pixels on the first surface in plan view.
